(19) Europäisches Patentamt / European Patent Office / Office européen des brevets

(11) **EP 2 221 140 B1**

(12) **EUROPEAN PATENT SPECIFICATION**

(45) Date of publication and mention
of the grant of the patent:
**25.09.2013 Bulletin 2013/39**

(21) Application number: **08854783.1**

(22) Date of filing: **25.11.2008**

(51) Int Cl.:
*B23K 35/363* *(2006.01)*     *H05K 3/34* *(2006.01)*
*B23K 35/36* *(2006.01)*      *B23K 35/362* *(2006.01)*
*B23K 35/02* *(2006.01)*

(86) International application number:
**PCT/JP2008/071357**

(87) International publication number:
**WO 2009/069601 (04.06.2009 Gazette 2009/23)**

(54) **FLUX FOR SOLDERING, SOLDERING PASTE COMPOSITION, AND METHOD OF SOLDERING**

FLUSSMITTEL ZUM LÖTEN, LÖTPASTENZUSAMMENSETZUNG UND LÖTVERFAHREN

FLUX DE BRASAGE TENDRE, COMPOSITION À BRASER ET PROCÉDÉ DE BRASAGE ASSOCIÉ

(84) Designated Contracting States:
**AT BE BG CH CY CZ DE DK EE ES FI FR GB GR
HR HU IE IS IT LI LT LU LV MC MT NL NO PL PT
RO SE SI SK TR**

(30) Priority: **27.11.2007 JP 2007305637**

(43) Date of publication of application:
**25.08.2010 Bulletin 2010/34**

(73) Proprietor: **Harima Chemicals, Inc.
Hyogo 675-0019 (JP)**

(72) Inventors:
• **ISHIKAWA, Shunsuke
Kakogawa-shi
Hyogo 675-0019 (JP)**
• **SHINOZUKA, Akira
Kakogawa-shi
Hyogo 675-0019 (JP)**
• **AIHARA, Masami
Kakogawa-shi
Hyogo 675-0019 (JP)**

(74) Representative: **Ackroyd, Robert
WP Thompson
55 Drury Lane
London
WC2B 5SQ (GB)**

(56) References cited:
EP-A1- 1 439 025     EP-A1- 1 897 652
JP-A- 8 132 282      JP-A- 8 132 282
JP-A- 9 192 883      JP-A- 9 192 883
JP-A- 10 034 383     JP-A- 63 289 991
JP-A- 63 289 991     JP-A- 2001 114 747
JP-A- 2001 114 747   JP-T- 2002 514 973
US-A- 5 904 782      US-A- 5 989 362

**Description**

TECHNICAL FIELD

The present invention relates to a soldering flux and a solder paste composition that is used, for example, at the time of performing solder connection of a circuit component or the like to a circuit substrate, and relates to a soldering method using them.

BACKGROUND ART

Generally, a solder paste composition is constructed with a flux composed of a base resin such as rosins, a solvent, an activating agent, a thixotropic agent and the like, and a solder powder and the like. As the solvent used in the flux, a volatile organic compound (hereafter referred to as VOC) such as represented by diethylene glycol monobutyl ether (butylcarbitol) or diethylene glycol mono- n- hexyl ether (hexylcarbitol) is generally used. The reason why such a solvent is used lies in that it is excellent in the solubility of the flux component, that a viscosity stability at the time of continuous printing can be easily ensured, and that it has an excellent property that the electric insulation resistance is not deteriorated because it will be volatilized when the solder is melted.

However, VOC can be a causing substance of photochemical oxidant, and therefore in recent years, a measure for limiting the use thereof (VOC countermeasure) is demanded in view of the consideration to the earth environment. As a VOC countermeasure, for example, a water- soluble solder paste in which the solvent is replaced with water by using a water- soluble substance as a flux component (see patent document 1), and a soldering flux in which water is used as a solvent, and a conventional hydrophobic base resin is dispersed (see patent document 2) are proposed.

However, when a water- soluble solder paste of patent document 1 is used, a water- washing step, a water- rinsing step, and the like will be needed, thereby raising a problem of increasing the number of steps to increase the product costs of electronic components or the like, and also raising a problem such that it necessitates processing of a waste liquid generated in the washing or rinsing step or the like. On the other hand, in the soldering flux of patent document 2, non- water- soluble resin is emulsified or  dispersed, so that there is a problem the stability at the time of use or at the time of storage, and also, it is extremely difficult to maintain the stability of the dispersed particles when the flux is kneaded with a solder powder to make a solder paste.

For this reason, as a VOC countermeasure in a soldering flux, a measure as a solvent except for water, which uses an organic solvent having a high boiling point that is volatilized little in reflowing is considered as prospective. However, a flux containing an ordinary amount of an organic solvent having a high boiling point results in a poor drying property, raising a problem that the stickiness of the flux residue after soldering will be high, or a problem that migration occurs to decrease the reliability. Therefore, when an organic solvent having a high boiling point is used, the content of the solvent in the flux must be designed to be low to some degree.

However, when the content of the solvent is reduced, the viscosity of a produced solder paste becomes high, so that the workability decreases considerably.

Accordingly, it is the current state that a VOC countermeasure suppressing the stickiness of the flux residue and enabling soldering with a high reliability while using an ordinary amount of solvent so that a good  workability may be ensured has not been established.

[patent document 1] Japanese Patent unexamined Application Laid-open No. H10-85985
[patent document 2] Japanese Patent unexamined Application Laid-open No. 2007-144446

EP 1439025 discloses a non-curing soldering flux composition comprising at least one compound having at least one blocked carboxyl group (sometimes referred to as compound (A) hereinbelow) selected from the group consisting of: compound (X) obtained by reaction of a carboxylic acid compound and a vinyl ether compound; compound (Y) obtained by reaction of a carboxylic acid anhydride compound and a hydroxy vinyl ether compound; and compound (Z) obtained by reaction of an acid anhydride and a polyhydric alcohol, followed by addition polymerization with a divinyl ether compound. There is also provided a solder paste comprising the above-mentioned soldering flux composition and solder powder as well as a method of soldering. The soldering flux also contains oil commonly used in the field. Flux residues can be suppressed. The amount of the organic solvent is not particularly limited, and is 5 to 95 parts by weight, preferably 20 to 80 parts by weight.

DISCLOSURE OF THE INVENTION

The present invention has been completed in view of the aforementioned circumstances, and an object thereof is to provide a soldering flux in which the volatilized amount in reflowing is reduced to enable soldering with a small load to the environment while suppressing the stickiness of the flux residue to ensure a high reliability. Also, there is provided a solder paste composition and a soldering method using the above soldering flux.

The present inventors have repeatedly made eager researches in order to solve the aforementioned problems and, as a result, have found out a new fact that, when an organic acid anhydride that is in liquid form at 20°C or higher and a polyhydric alcohol that is in liquid form at 20°C or higher are used as solvents in the flux at a specific ratio in combination, the two solvents undergo esterification reaction to be hardened by being heated in reflowing, so that the volatilized amount in reflowing can be greatly reduced, and also the residual of liquid substances in the flux residue can be suppressed, thereby solving problems such as increase in the stickiness of the residue and decrease in the reliability, thereby completing the present invention.

Namely, the soldering flux of the present invention comprises a base resin, an activating agent, and a solvent, wherein the solvent contains an organic acid anhydride that is in liquid form at 20°C or higher and a polyhydric alcohol that is in liquid form at 20°C or higher, and when the acid value of the organic acid anhydride is denoted as AV (mgKOH/g), the content of the organic acid anhydride is denoted as $W_A$ (g), the hydroxyl value of the polyhydric alcohol is denoted as OHV (mgKOH/g), and the content of the polyhydric alcohol is denoted as $W_{OH}$ (g), then $(AV \times W_A) : (OHV \times W_{OH})$ = 1 : 0.4 to 0.6. It is preferable that the content of the organic acid anhydride is 10 to 50 % by weight, the content of the polyhydric alcohol is 5 to 40 % by weight, and the combined content of the organic acid anhydride and the polyhydric alcohol is 15 to 80 % by weight, relative to the total amount of the flux. Also, the soldering flux preferably contains also an oil component having an iodine value of 120 to 170. More preferably, the oil component contains at least one of drying oil and semidrying oil. Still more preferably, the oil component contains one or more kinds selected from the group consisting of tung oil, poppy-seed oil, walnut oil, safflower oil, sunflower oil, and soybean oil.

The solder paste composition of the present invention comprises the soldering flux of the present invention described above and a solder alloy powder.

The soldering method of the present invention comprises using a solder paste composition containing the soldering flux of the present invention described above and a solder alloy powder, and allowing the organic acid anhydride and the polyhydric alcohol in the flux to undergo hardening reaction at the time of reflowing.

According to the present invention, since an organic acid anhydride and a polyhydric alcohol that can be hardened by esterification reaction at the time of heating are used as solvents contained in the flux, an effect can be obtained such that the volatilized amount in reflowing is greatly reduced to enable soldering with a small load to the environment while suppressing the stickiness of the flux residue to ensure a high reliability.

BEST MODES FOR CARRYING OUT THE INVENTION

Hereafter, one embodiment of the present invention will be described in detail.

The soldering flux (which may hereafter be simply referred to as "flux") of the present invention contains an organic acid anhydride that is in liquid form at 20°C or higher and a polyhydric alcohol that is in liquid form at 20°C or higher as solvents. By using an organic acid anhydride and a polyhydric alcohol that are in liquid form at an ordinary temperature (room temperature) as solvents, the two solvents function as a solvent in a liquid form to ensure a good workability when the solder paste composition is used for soldering. Also, at the time of reflowing, the two solvents undergo esterification reaction to be hardened by being heated. As a result, the volatilized amount at the time of reflowing can be greatly reduced, and also the residual of liquid substances in the flux residue can be suppressed, whereby problems such as increase in the stickiness of the residue and decrease in the reliability are avoidable.

The organic acid anhydride may be, for example, a general organic acid anhydride in liquid form, such as propionic anhydride, butyric anhydride, trifluoroacetic anhydride, methyl-tetrahydrophthalic anhydride, methylhexahydrophthalic anhydride, methyl-endomethylene-tetrahydrophthalic anhydride, or dimethyl-eicosadienedioic anhydride. The organic acid anhydride may be one kind alone or two or more kinds.

The polyhydric alcohol may be, for example, a general polyhydric alcohol in liquid form, such as glycerin, propylene glycol, 1,3-butylene glycol, triethylene glycol, diglycerin-propylene oxide adduct, castor oil polyol, polyethylene glycol, polypropylene glycol, or polyglycerin. The polyhydric alcohol may be one kind alone or two or more kinds.

In order to prevent also the volatilization at the initial stage of heating in solder melting with certainty, the organic acid anhydride and the polyhydric alcohol each preferably has a boiling point exceeding 260°C, and more preferably has a boiling point exceeding 400°C. When the boiling point is lower than or equal to 260°C, the volatilization is liable to take place at the initial stage of heating in reflowing (namely, in solder melting), so that a sufficient effect cannot be obtained as a countermeasure against VOC. In addition, when one of the organic acid anhydride and the polyhydric alcohol is volatilized in a greater amount in reflowing (namely, in solder melting), the hardening of the film by the esterification reaction will be insufficient, thereby raising a fear that a problem such as stickiness of the flux residue or decrease in the reliability may be generated. From such a viewpoint, the organic acid anhydride is especially preferably methyl-endomethylene-tetrahydrophthalic anhydride or dimethyl-eicosadienedioic anhydride, and the polyhydric alcohol is especially preferably diglycerin-propylene oxide adduct or castor oil polyol.

In the flux of the present invention, it is important to satisfy $(AV \times W_A) : (OHV \times W_{OH}) = 1 : 0.4$ to $0.6$, where the acid value of the organic acid anhydride is denoted as AV (mgKOH/g), the content thereof is denoted as $W_A$ (g), the hydroxyl value of the polyhydric alcohol is denoted as OHV (mgKOH/g), and the content thereof is denoted as $W_{OH}$ (g) . Here, "$AV \times W_A$" means the amount (mg) of potassium hydroxide that is needed to neutralize $W_A$ (g) of the organic acid anhydride. On the other hand, "$OHV \times W_{OH}$" means the amount (mg) of potassium hydroxide that is needed to neutralize the acetic acid that is bonded to the hydroxyl group when $W_{OH}$ (g) of the polyhydric alcohol is acetylated. In the flux of the present invention, by determining the content (the content ratio) of the organic acid anhydride and the polyhydric alcohol on the basis of the acid value of the organic acid anhydride and the hydroxyl value of the polyhydric alcohol, the esterification reaction of both compounds can be allowed to proceed efficiently without leaving one as a residue. Preferably, $(AV \times W_A) : (OHV \times W_{OH}) = 1 : 0.45$ to $0.55$, and most preferably, $(AV \times W_A) : (OHV \times W_{OH}) = 1 : 0.5$. When the organic acid anhydride used as the solvent is two or more kinds, the value of the "$AV \times W_A$" may be calculated by adding the product of each acid value ($A^1V$, $A^2V$, ..., $A^nV$) of the organic acid anhydride ($A^1$, $A^2$, ... , $A^n$) by each content ($W_A^1$, $W_A^2$, ..., $W_A^n$) of the organic acid anhydride ($A^1$, $A^2$, ..., $A^n$) . Namely, when two or more kinds of organic acid anhydride are used in combination, the value of "$AV \times W_A$" can be determined by the formula: $[AV \times W_A = A^1V \times W_A^1 + A^2V \times W_A^2 + ... + A^nV \times W_A^n]$ .

Similarly, when the polyhydric alcohol used as the solvent is two or more kinds, the value of the "$OHV \times W_{OH}$" may be calculated by adding the product of each hydroxyl value ($OH^1V$, $OH^2V$, ..., $OH^nV$) of the polyhydric alcohol ($OH^1$, $OH^2$, ..., $OH^n$) by each content ($W_{OH}^1$, $W_{OH}^2$, ..., $W_{OH}^n$) of the polyhydric alcohol ($OH^1$, $OH^2$, ..., $OH^n$) . Namely, when two or more kinds of polyhydric alcohol are used in combination, the value of "$OHV \times W_{OH}$" can be determined by the formula: $[OHV \times W_{OH} = OH^1V \times W_{OH}^1 + OH^2V \times W_{OH}^2 + ... + OH^nV \times W_{OH}^n]$ .

The content of the organic acid anhydride may be preferably 10 to 50 % by weight and more preferably 15 to 35 % by weight relative to the total amount of the flux. When the content of the organic acid anhydride is lower than 10 % by weight, the amount of the polyhydric alcohol that is added so that the ratio of $(AV \times W_A) : (OHV \times W_{OH})$ is within a specific range in order to allow the esterification reaction to proceed efficiently will inevitably be small, so that the components in liquid form will be small in amount, thereby raising a fear of decrease in the workability due to the viscosity of the flux becoming higher. Conversely, when the content of the organic acid anhydride exceeds 50 % by weight, the amount of the polyhydric alcohol to be added is also increased, whereby workability may be lowered due to the low viscosity of the flux.

The content of the polyhydric alcohol is preferably 5 to 40 % by weight and more preferably 8 to 20 % by weight relative to the total amount of the flux. When the content of the polyhydric alcohol is lower than 5 % by weight, the amount of the organic acid anhydride that is added so that the ratio of $(AV \times W_A) : (OHV \times W_{OH})$ is within a specific range in order to allow the esterification reaction to proceed efficiently will inevitably be small, so that the components in liquid form will be small in amount, thereby raising a fear of decrease in the workability due to the viscosity of the flux becoming higher. Conversely, when the content of the polyhydric alcohol exceeds 40 % by weight, the amount of the organic acid anhydride to be added is also increased, whereby workability may be lowered due to the low viscosity of the flux.

Also, the total content of the organic acid anhydride and the polyhydric alcohol is preferably 15 to 80 % by weight and more preferably 20 to 50 % by weight relative to the total amount of the flux. When the total content of the organic acid anhydride and the polyhydric alcohol is lower than 15 % by weight, the components in liquid form in the flux will be small in amount, thereby raising a fear of considerable decrease in the workability due to the high viscosity of the flux. On the other hand, when the total content exceeds 80 % by weight, the components for cleaning the solder metal become small in amount, thereby raising a fear that a sufficient solderability may not be obtained, and also raising a fear of decrease in the workability due to the low viscosity of the flux.

The flux of the present invention preferably contains an oil component having an iodine value of 120 to 170 as a solvent in addition to the organic acid anhydride and the polyhydric alcohol. Here, the oil component means one kind of oil or a mixture of two or more kinds of oil. The oil is typically in liquid form at an ordinary temperature (room temperature). For this reason, when an oil component is also used as a solvent together with the organic acid anhydride and the polyhydric alcohol, the oil component functions as a solvent in liquid form to ensure a good workability when using for soldering in form of the solder paste composition. Also, at the time of reflowing, the oil component reacts with oxygen in air to cause oxidation polymerization to be hardened. As a result, the volatilized amount in reflowing can be greatly reduced, and also the residual of liquid substances in the flux residue can be suppressed.

The iodine value of the oil component is 120 to 170 and more preferably 125 to 165. When the iodine value of the oil component is lower than 120, the hardening of the film by oxidation polymerization in reflowing will be insufficient, thereby raising a fear of inviting stickiness of the residue or decrease in the reliability. On the other hand, when the iodine value exceeds 170, an excessive oxidation polymerization reaction proceeds at the time of storing or working the flux or the solder paste composition. As a result, the viscosity rises to deteriorate the stability, thereby raising a fear of lowering the workability.

When the oil component is composed of two or more kinds of oil, it is sufficient that the iodine value of the oil component as a whole is 120 to 170.

The oil component preferably contains at least one of drying oil and semidrying oil. In particular, the oil component more preferably contains at least one of drying oil having an iodine value of 120 to 170 and semidrying oil having an iodine value of 120 to 170. The drying oil having an iodine value of 120 to 170 may be, for example, tung oil, poppy-seed oil, walnut oil, or safflower oil. The semidrying oil having an iodine value of 120 to 170 may be, for example, sunflower oil or soybean oil.

When the oil component is composed of two or more kinds of oil, the oil component is preferably composed only of at least one of drying oil and semidrying oil, and more preferably is composed only of at least one of drying oil having an iodine value of 120 to 170 and semidrying oil having an iodine value of 120 to 170. However, as long as the mixing ratio of oils is adjusted so that the iodine value of the mixed oil component as a whole will be 120 to 170, the oil component may contain oil having an iodine value of less than 120 or oil having an iodine value exceeding 170. The oil having an iodine value of less than 120 may be, for example, jojoba oil, castor oil, coconut oil, sesame oil, or the like. The oil having an iodine value exceeding 170 may be, for example, linseed oil, beefsteak plant oil, or the like.

When the oil component is also contained as the solvents, the content of the oil component contained in the flux (when it is a mixture of two or more kinds of oil, the combined content) is preferably 45 % by weight or less and more preferably 35 % by weight or less relative to the total amount of the flux. When the content of the oil component exceeds 45 % by weight, the total amount of liquid components adding the organic acid anhydride and the polyhydric alcohol will be larger, raising a fear that the workability may deteriorate due to the low viscosity of the flux.

The flux of the present invention may contain, for example, a high-boiling-point solvent that is conventionally used generally in a flux, such as an ether type solvent or an ester type solvent, within a range that does not deteriorate the effects of the present invention, in addition to the solvents described above. In that case, in consideration of the purpose of the present invention, it is preferable to use a solvent which is a polar solvent that can dissolve flux components such as a base resin and an activating agent and which has a boiling point of 400°C or higher. Such a high-boiling-point solvent may be, for example, an ether compound or an ester compound of polyethylene glycol, polypropylene glycol, polyglycerin, or the like, trimellitic acid ester, phthalic acid ester, sorbitol ether, or the like. Typically, the content of these high-boiling-point solvents is preferably 30 % by weight or less relative to the total amount of the flux.

In addition to the solvents, the flux of the present invention contains a base resin and an activating agent, and may further contain a thixotropic agent and other additives in accordance with the needs.

The base resin may be, for example, an ordinary rosin or a derivative thereof that is conventionally used generally in a flux, or a synthetic resin that is conventionally used generally in a flux. The rosin may be, for example, gum rosin, tall oil rosin, wood rosin, or the like. The rosin derivative may be, for example, polymerized rosin, acrylated rosin, hydrogenated rosin, formylated rosin, rosin ester, rosin-modified maleic acid resin, rosin-modified phenolic resin, rosin-modified alkyd resin, or the like. The synthetic resin may be, for example, styrene-maleic acid resin, epoxy resin, urethane resin, or the like. The content of the base resin is not particularly limited; however, the content is preferably 5 to 75 % by weight relative to the total amount of the flux.

The activating agent is not particularly limited; however, in consideration of the purpose of the present invention which is a VOC countermeasure, the activating agent preferably has a low volatility. The activating agent may be, for example, a hydrohalide such as ethylamine, propylamine, diethylamine, triethylamine, ethylenediamine, aniline, or the like; an organic carboxylic acid such as lactic acid, citric acid, stearic acid, adipic acid, tridecanedioic acid, dodecanedioic acid, or the like. The content of the activating agent is not particularly limited; however, the content is preferably 0.1 to 20 % by weight relative to the total amount of the flux. When the amount of the activating agent is less than 0.1 % by weight, the activating power will be insufficient, raising a fear that the solderability may decrease. On the other hand, when the amount of the activating agent exceeds 20 % by weight, the coating film property of the flux will decrease, and hydrophilicity is enhanced, whereby the corrosion property and the insulation property may decrease.

The thixotropic agent is not particularly limited; however, the thixotropic agent may be, for example, hardened castor oil, beeswax, carnauba wax, stearic acid amide, hydroxystearic acid ethylenebisamide, or the like. The content of the thixotropic agent is not particularly limited; however, the content is preferably 0.5 to 25 % by weight relative to the total amount of the flux.

The other additives may be, for example, an antioxidant, a rust-preventive agent, a chelating agent, or the like. The content of these other additives may be suitably set within a range that does not deteriorate the effect of the present invention.

The solder paste composition of the present invention contains the soldering flux of the present invention described above and a solder alloy powder.

The solder alloy powder is not particularly limited, and it is possible to use a tin-lead alloy that is generally used, or further a tin-lead alloy to which silver, bismuth, indium, or the like has been added. Also, a lead-free alloy such as tin-silver type, tin-copper type, or tin-silver-copper type may be used. The particle size of the solder alloy powder of preferably about 5 to 50 μm.

The ratio of the flux and the solder alloy powder in the solder paste composition of the present invention may be suitably set in accordance with the usage or function of the desired solder paste, and is not particularly limited; however, the ratio of flux : solder alloy powder (weight ratio) is preferably about 5 : 95 to 20 : 80.

The soldering method of the present invention uses the solder paste composition of the present invention described above and allows the organic acid anhydride and the polyhydric alcohol in the flux to undergo hardening reaction at the time of reflowing. In this case, the reflow may be carried out at the maximum temperature of about 170 to 250°C after preheating is carried out at about 150 to 200°C; however, the method is not limited thereto. In soldering, the solder paste composition is applied onto a substrate by a dispenser, screen printing, or the like.

The soldering method of the present invention can be suitably used, for example, in performing solder connection of electronic device component or the like.

[EXAMPLES]

Hereafter, the present invention will be described in more detail by raising Examples and Comparative Examples; however, the present invention is not limited to the following Examples.

(Examples 1 to 9 and Comparative Examples 1 to 3)

Among the components of the flux shown in Table 1 and Table 2, all the components excluding the organic acid anhydride in liquid form were put into a container at a blending ratio shown in Table 1 and Table 2, and were heated and dissolved, followed by cooling. After the cooling, organic acid anhydride in liquid form in an amount attaining the blending composition shown in Table 1 and Table 2 was added to the obtained mixture, thereby to obtain fluxes, respectively.

As the organic acid anhydride in liquid form, at least one of methyl-endomethylene-tetrahydrophthalic anhydride having an acid value of 315 mgKOH/g ("MHAC-P" manufactured by Hitachi Chemical Co., Ltd.; in the Tables, this is represented as "organic acid anhydride (A)") and dimethyl-eicosadienedioic anhydride having an acid value of 300 mgKOH/g ("IPU-22AH" manufactured by Okamura Seiyu Co., Ltd.; in the Tables, this is represented as "organic acid anhydride (B)") was used. Further, as the polyhydric alcohol in liquid form, at least one of diglycerin-propylene oxide adduct having a hydroxyl value of 300 mgKOH/g ("SY-DP9" manufactured by Sakamoto Yakuhin Kogyo Co., Ltd.; in the Tables, this is represented as "polyhydric alcohol (A)") and castor oil polyol having a hydroxyl value of 320 mgKOH/g ("URIC H-102" manufactured by Itoh Oil Chemicals Co., Ltd.; in the Tables, this is represented as "polyhydric alcohol (B)") was used.

Next, in the container, each of the obtained fluxes and a solder alloy powder (melting point: 219°C, particle size: 30 to 20 $\mu$m) made of Sn- Ag- Cu alloy (Sn : Ag : Cu (weight ratio) = 96.5 : 3.0 : 0.5) were mixed at a ratio of flux : solder alloy powder (weight ratio) = 11 : 89 and stirred to obtain solder paste compositions, respectively.

Each of the obtained solder paste compositions was evaluated by the following methods. The results are shown in Table 1 and Table 2.

<Volatility of flux>

A solder paste composition was printed onto a copper plate (80 mm $\times$ 40 mm $\times$ 0.3 mm) with use of a metal mask having a thickness of 150 $\mu$m and having ten openings of 10 mm $\times$ 10 mm. In this case, the weight (a) of the copper plate immediately after the printing was measured, so as to determine the weight (A) of the solder paste composition that had been printed from the weight difference of the copper plate before and after the printing. Within 30 minutes after the printing, preheating was carried out in an ambient atmosphere at 175 $\pm$ 5°C for 80 $\pm$ 5 seconds, and reflowing was carried out at the maximum temperature of 235 $\pm$ 5°C. The weight (b) of the copper plate after the reflowing was measured, so as to calculate the volatility ratio (%) of the flux based on the following formula from the weight difference (a - b) before and after the reflowing and the flux content (namely, 11 % by weight).

$$\text{Volatility ratio (\%)} = [(a - b) / (A \times 0.11)] \times 100$$

<Insulation property>

On a comb- shaped substrate (II type) defined in JIS- Z- 3197, a solder paste composition was printed with use of a metal mask having a thickness of 100 $\mu$m and having the same pattern. Within 10 minutes after the printing, preheating was carried out in an ambient atmosphere at 175 $\pm$ 5°C for 80 $\pm$ 5 seconds, and reflow was carried out at the maximum temperature of 235 $\pm$ 5°C. After reflow, the substrate was left to stand in a thermostat humidistat tank having a temperature of 85°C and a humidity of 85%. By measuring the resistance value ($\Omega$) after 1000 hours, the insulation property was evaluated as an index of electric reliability.

For example, when the resistance value of Example 1 was $5 \times 10^9$ $\Omega$, this is denoted as "5E9" in Table 1 and Table 2. The other resistance values are also denoted in the same manner.

<Corrosion property>

With use of the solder paste composition, a copper plate corrosion test piece defined in JIS-Z-3284 was prepared and, after the test piece was left to stand in a thermostat humidistat tank having a temperature of 40°C and a humidity of 85% for 96 hours, observation by eye inspection was carried out to confirm the presence or absence of the corrosion generation.

<Stickiness of residue>

With use of the solder paste composition, a drying degree test piece defined in JIS-Z-3284 was prepared. After talc powder was attached to the test piece cooled to ordinary temperature, the surface was lightly brushed with a soft brush. At this time, observation by eye inspection was carried out to confirm the presence or absence of the attachment of powder talc.

[TABLE 1]

| | | | Examples | | | | | | | | |
|---|---|---|---|---|---|---|---|---|---|---|---|
| | | | 1 | 2 | 3 | 4 | 5 | 6 | 7 | 8 | 9 |
| Flux composition / wt % | Gum rosin | | 57.5 | 55.0 | 47.3 | 50.5 | 50.5 | 50.5 | 35.1 | 35.1 | 38.1 |
| | Hardened castor oil | | 5.0 | 5.0 | 5.0 | 5.0 | 5.0 | 5.0 | 5.0 | 5.0 | 5.0 |
| | Organic acid anhydride (A) (Acid value : 315mgKOH/g) | | 21.0 | — | 27.0 | — | — | 11.5 | 18.0 | — | 17.0 |
| | Organic acid anhydride (B) (Acid value : 300mgKOH/g) | | — | 24.5 | — | 26.0 | 25.0 | 16.0 | — | 20.0 | — |
| | Dodecanedioic acid | | 5.0 | 5.0 | 5.0 | 5.0 | 5.0 | 5.0 | 5.0 | 5.0 | 5.0 |
| | Ethylamine hydrochloride | | 0.5 | 0.5 | 0.5 | 0.5 | 0.5 | 0.5 | 0.5 | 0.5 | 0.5 |
| | Polyhydric alcohol (A) (Hydroxyl value:300mgKOH/g) | | 11.0 | — | — | 13.0 | 7.0 | 6.0 | 9.4 | — | — |
| | Polyhydric alcohol (B) (Hydroxyl value:320mgKOH/g) | | — | 10.0 | 15.2 | — | 7.0 | 5.5 | — | 9.3 | 8.4 |
| | Tung oil (Iodine value : 165) | | — | — | — | — | — | — | 27.0 | — | 13.0 |
| | Soybean oil (Iodine value : 128) | | — | — | — | — | — | — | — | 25.1 | 13.0 |
| $AV \times W_A : OHV \times W_{OH}$ * | | | 1:0.5 | 1:0.4 | 1:0.6 | 1:0.5 | 1:0.6 | 1:0.4 | 1:0.5 | 1:0.5 | 1:0.5 |
| Examination results | Volatility of flux : volatility ratio(%) | | 3.9 | 3.1 | 3.6 | 4.1 | 3.8 | 4.2 | 3.7 | 4.3 | 3.9 |
| | Insulation property : Resistance value ($\Omega$) | | 5E9 | 4E9 | 6E9 | 5E9 | 3E9 | 6E9 | 6E9 | 8E9 | 6E9 |
| | Corrosion property : Corrosion generation | | Non | Non | Non | Non | Non | Non | Non | Non | Non |
| | Stickiness of residue : Attachment of talc powder | | Non | Non | Non | Non | Non | Non | Non | Non | Non |

* AV denotes the acid value of the organic acid anhydride, and $W_A$ denotes the content of the organic acid anhydride.

OHV denotes the hydroxyl value of the polyhydric alcohol, and $W_{OH}$ denotes the content of the polyhydric alcohol.

8

[TABLE 2]

| | | Comparative Examples | | |
|---|---|---|---|---|
| | | 1 | 2 | 3 |
| Flux composition / wt % | Gum rosin | 53.5 | 57.5 | 49.5 |
| | Hardened castor oil | 5.0 | 5.0 | 5.0 |
| | Organic acid anhydride (B) (Acid value : 300mgKOH/g) | — | — | 20.0 |
| | Dodecanedioic acid | 5.0 | 5.0 | 5.0 |
| | Phthalic acid | — | 15.0 | — |
| | Ethylamine hydrochloride | 0.5 | 0.5 | 0.5 |
| | Polyhydric alcohol (A) (Hydroxyl value:300mgKOH/g) | — | — | 20.0 |
| | Polyhydric alcohol (B) (Hydroxyl value:320mgKOH/g) | — | 17.0 | — |
| | Hexylcarbitol | 36.0 | — | — |
| AV× $W_A$ : OHV×$W_{OH}$ * | | — | — | 1:1 |
| Examination results | Volatility of flux : volatility ratio (%) | 39.6 | 25.1 | 10.2 |
| | Insulation property : Resistance value (Ω) | 6E9 | 2E7 | 6E7 |
| | Corrosion property : Corrosion generation | Non | Yes | Yes |
| | Stickiness of residue : Attachment of talc powder | Non | Yes | Yes |

* AV denotes the acid value of the organic acid anhydride, and $W_A$ denotes the content of the organic acid anhydride.

OHV denotes the hydroxyl value of the polyhydric alcohol, and $W_{OH}$ denotes the content of the polyhydric alcohol.

From Table 1, it is understood that, according to the solder paste compositions of Examples 1 to 9 in which an organic acid anhydride and a polyhydric alcohol are used at a specific ratio as the solvents in the flux, the generation of volatile substances is suppressed in reflowing (in melting the solder by heating), and also hardening occurs by esterification reaction, so that there is no generation of inconveniences such as decrease in the insulation property, corrosion, and stickiness generation of the residue, whereby the load to the environment can be reduced while maintaining a high reliability.

On the other hand, as being apparent from Table 2, in a conventional solder paste composition of Comparative Example 1 using hexylcarbitol which is a volatile organic compound as the solvent in the flux, though a high reliability is provided, there arises a problem that the volatility of the flux is high and the load to the environment is large. In a solder paste composition of Comparative Example 2 using polyhydric alcohol and organic acid (phthalic acid) as the solvents in the flux, the hardening reaction does not proceed because organic acid anhydride is not contained. As a result, there arises a problem that the amount of volatile substances cannot be sufficiently suppressed, and the properties such as insulation, corrosion property and stickiness of the residue are aggravated because the liquid form polyhydric alcohol having a high boiling point remains. In the solder paste composition of Comparative Example 3 in which, though an organic acid anhydride and a polyhydric alcohol are used as the solvents in the flux, the ratio of the acid value of the organic acid anhydride and the hydroxyl value of the polyhydric alcohol is out of the range of the present invention, there arises a problem that deterioration of properties such as insulation property, corrosion property, and stickiness of the residue is generated due to residual of the high-boiling-point components that do not contribute to the esterification reaction.

As shown above, the soldering flux and the solder paste composition pertaining to the present invention have been described in detail; however, the scope of the present invention is not restricted by these descriptions, so that suitable changes or modifications can be made within a range that does not deteriorate the gist of the present invention.

## Claims

1. A soldering flux comprising a base resin, an activating agent, and a solvent, wherein the solvent comprises an organic acid anhydride that is in liquid form at 20°C or higher and a polyhydric alcohol that is in liquid form at 20°C or higher, and when the acid value of the organic acid anhydride is denoted as AV (mgKOH/g), the content of the organic acid anhydride is denoted as $W_A$(g), the hydroxyl value of the polyhydric alcohol is denoted as OHV (mgKOH/g), and the content of the polyhydric alcohol is denoted as $W_{OH}$(g), then $(AV \times W_A) : (OHV \times W_{OH}) = 1 : 0.4$ to 0.6.

2. The soldering flux according to claim 1, wherein the content of the organic acid anhydride is 10 to 50 % by weight, the content of the polyhydric alcohol is 5 to 40 % by weight, and the combined content of the organic acid anhydride and the polyhydric alcohol is 15 to 80 % by weight, relative to the total amount of the flux.

3. The soldering flux according to claim 1 or 2, which also contains an oil component having an iodine value of 120 to 170.

4. The soldering flux according to claim 3, wherein said oil component comprises at least one of drying oil and semidrying oil.

5. The soldering flux according to claim 4, wherein said oil component contains one or more kinds selected from the group consisting of tung oil, poppy-seed oil, walnut oil, safflower oil, sunflower oil, and soybean oil.

6. A solder paste composition comprising the soldering flux according to any one of claims 1 to 5 and a solder alloy powder.

7. A soldering method which comprises using a solder paste composition comprising the soldering flux according to any one of claims 1 to 5 and a solder alloy powder, and allowing the organic acid anhydride and the polyhydric alcohol in the flux to undergo hardening reaction in reflowing.

## Patentansprüche

1. Lötflussmittel, das ein Grundharz, ein Aktivierungsmittel und ein Lösungsmittel umfasst, worin das Lösungsmittel ein organisches Säureanhydrid, das bei 20°C oder höher in flüssiger Form vorliegt, und einen mehrwertigen Alkohol, der bei 20°C oder höher in flüssiger Form vorliegt, umfasst und, wenn die Säurezahl des organischen Säureanhydrids als AV (mgKOH/g) bezeichnet wird, der Gehalt des organischen Säureanhydrids als $W_A$ (g) bezeichnet wird, die Hydroxylzahl des mehrwertigen Alkohols als OHV (mgKOH/g) bezeichnet wird und der Gehalt des mehrwertigen Alkohols als $W_{OH}$ (g) bezeichnet wird, dann $(AV \times W_A) : (OHV \times W_{OH}) = 1 : 0,4$ bis 0,6.

2. Lötflussmittel nach Anspruch 1, worin der Gehalt des organischen Säureanhydrids 10 bis 50 Gewichts-% beträgt, der Gehalt des mehrwertigen Alkohols 5 bis 40 Gewichts-% beträgt und der kombinierte Gehalt des organischen Säureanhydrids und des mehrwertigen Alkohols 15 bis 80 Gewichts-% beträgt, bezogen auf die Gesamtmenge des Flussmittels.

3. Lötflussmittel nach Anspruch 1 oder 2, das auch eine Ölkomponente mit einer Iodzahl von 120 bis 170 enthält.

4. Lötflussmittel nach Anspruch 3, worin die genannte Ölkomponente mindestens eines von einem trocknenden Öl und halbtrocknenden Öl umfasst.

5. Lötflussmittel nach Anspruch 4, worin die genannte Ölkomponente eine oder mehrere Arten enthält, die aus der Gruppe ausgewählt sind, die aus Tungöl, Mohnöl, Walnussöl, Distelöl, Sonnenblumenöl und Sojaöl besteht.

6. Lötpastenzusammensetzung, die das Lötflussmittel nach einem der Ansprüche 1 bis 5 und ein Lötlegierungspulver umfasst.

7. Lötverfahren, das das Verwenden einer Lötpastenzusammensetzung, die das Lötflussmittel nach einem der Ansprüche 1 bis 5 und ein Lötlegierungspulver umfasst, und das Ermöglichen, dass das organische Säureanhydrid und der mehrwertige Alkohol in dem Flussmittel eine Härtungsreaktion beim Verfließen eingehen, umfasst.


**Revendications**

1. Fondant de soudure comprenant une résine de base, un agent activant, et un solvant, dans lequel le solvant comprend un anhydride d'acide organique qui se trouve sous forme liquide à 20°C ou plus, et un alcool polyhydrique qui se trouve sous forme liquide à 20°C ou plus, et lorsque l'indice d'acide de l'anhydride d'acide organique est dénoté par AV (mg KOH/g), la teneur en anhydride d'acide organique est dénotée par $W_A$ (g), l'indice hydroxyle de l'alcool polyhydrique est dénoté par OHV (mg KOH/g), et la teneur en alcool polyhydrique est dénotée par $W_{OH}$ (g), alors $(AV \times W_A):(OHV \times W_{OH})$ = 1:0,4 à 0,6.

2. Fondant de soudure selon la revendication 1, dans lequel la teneur en anhydride d'acide organique va de 10 à 50% en poids, la teneur en alcool polyhydrique va de 5 à 40% en poids, et la teneur combinée en anhydride d'acide organique et en alcool polyhydrique va de 15 à 80% en poids, par rapport à la quantité totale du fondant.

3. Fondant de soudure selon la revendication 1 ou 2, contenant également un composant huileux ayant un indice d'iode allant de 120 à 170.

4. Fondant de soudure selon la revendication 3, dans lequel ledit composant huileux comprend au moins l'une parmi une huile siccative et une huile semi-siccative.

5. Fondant de soudure selon la revendication 4, dans lequel ledit composant huileux contient un ou plusieurs types choisis dans le groupe constitué par l'huile de bois de Chine, l'huile d'oeillette, l'huile de noix, l'huile de carthame, l'huile de tournesol et l'huile de soja.

6. Composition de pâte à braser, comprenant le fondant de soudure selon l'une quelconque des revendications 1 à 5 et une poudre d'alliage de soudure.

7. Méthode de soudure, comprenant l'utilisation d'une composition de pâte à braser comprenant le fondant de soudure selon l'une quelconque des revendications 1 à 5 et une poudre d'alliage de soudure, et l'étape consistant à permettre à l'anhydride d'acide organique et à l'alcool polyhydrique dans le fondant de subir une réaction de durcissement lors d'une refusion.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H1085985 B
- JP 2007144446 A
- EP 1439025 A